# EUROPEAN PATENT APPLICATION

(11) **EP 3 477 850 A1**
(43) Date of publication of application: **01.05.2019**
(21) Application number: 18737487.1
(22) Date of filing: 15.06.2018
(51) Int. Cl.: H02S 50/10

(54) **WET LEAKAGE CURRENT TEST SYSTEM FOR PHOTOVOLTAIC ASSEMBLY**

(30) Priority: 30.08.2017 CN 201721101267 U
(71) Applicant: Miasolé Equipment Integration (Fujian) Co., Ltd., 362000 Quanzhou Fujian (CN); Miasolé Equipment Integration (Fujian) Co., Ltd., 362005 Quanzhou Fujian (CN)
(72) Inventor: MA, Shengtao, Quanzhou Fujian 360025 (CN); LIU, Libing, Quanzhou Fujian 360025 (CN); LE, Chuanqin, Quanzhou Fujian 360025 (CN); HU, Binhua, Quanzhou Fujian 360025 (CN); XU, Yongyuan, Quanzhou Fujian 360025 (CN); ZENG, Jing, Quanzhou Fujian 360025 (CN); WU, Jianqing, Quanzhou Fujian 360025 (CN); JIANG, Mingwei, Quanzhou Fujian 360025 (CN)
(74) Representative: Isarpatent
(86) International application number: PCT/CN2018/091397
(87) International publication number: WO 2019/041971

(57) **Abstract**

The present disclosure discloses a wet leakage current test system for a photovoltaic component, comprising a liquid pool and a voltage-withstanding insulation tester as well as a first storage rack, a lifting actuator, a second storage rack, a drying apparatus and an electrical protection device; the first storage rack is arranged above the liquid pool, and is mechanically connected with the lifting actuator; the lifting actuator is configured to drive the first storage rack to descend into the liquid pool or ascend above the liquid pool; the drying apparatus is mounted on the second storage rack, for blowing air to a front surface and a back surface of the photovoltaic component laid flat on the second storage rack; and the electrical protection device is in electrical signal connection with the voltage-withstanding insulation tester, for disabling a voltage output from the voltage-withstanding insulation tester in the case that the operator operates in a high voltage region, and/or for cutting off a power source of the voltage-withstanding insulation tester in an emergency. The present disclosure can reduce human burden, save labor costs, improve test and production efficiencies, further eliminate safety hazards and ensure the reliability and safety during the test.

## Description

### CROSS-REFERENCE TO RELATED APPLICTION

The present application claims a priority of the Chinese Patent Application No. 201721101267.5 filed on August 30, 2017, the disclosures of which are incorporated in their entirety by reference herein.

### TECHNICAL FIELD

The present disclosure relates to the field of solar cell performance tests, in particular to a wet leakage current test system for a photovoltaic component.

### BACKGROUND

According to international standards, there is a strict requirement on the wet leakage current test of a photovoltaic component, with a purpose of verifying an insulating property of the component under a field humid environment, and avoiding corrosion, electric leakage or safety accidents due to moisture entering the component.

Existing wet leakage current test devices are usually operated manually. An operator transports the component into a liquid pool, applies a direct current (DC) voltage greater than 500 volts through a voltage-withstanding insulation tester, so as to test the component immersed in the liquid pool, and after the test is finished, manually picks up the component from a bottom of the liquid pool and places the same on a drying rack to be naturally air dried.

The above-mentioned operations have at least the following defects.

For a heavier double-glazed component, when testing, the component is picked up from and placed in the liquid pool by hand, which increases human burden. The natural-air drying process is time-consuming, which influences test and production efficiencies. Moreover, there is an electric shock risk for the operator.

### SUMMARY

An object of the present disclosure is to provide a wet leakage current test system for a photovoltaic component, so as to solve the above-mentioned problems.

The present disclosure adopts the following technical solution.

A wet leakage current test system for a photovoltaic component, including a liquid pool and a voltage-withstanding insulation tester, further includes: a first storage rack, a lifting actuator, a second storage rack, a drying apparatus and an electrical protection device, wherein the first storage rack is arranged above the liquid pool, mechanically connected with the lifting actuator, and configured to receive the photovoltaic component thereon; the lifting actuator is configured to drive the first storage rack to descend into the liquid pool or ascend above the liquid pool; the drying apparatus is mounted on the second storage rack, and configured to dry the photovoltaic component which moves from the first storage rack onto the second storage rack; and the electrical protection device is in electrical signal connection with the voltage-withstanding insulation tester, and configured to disable a voltage output from the voltage-withstanding insulation tester in the case that an operator operates in a high voltage region, and/or to cut off a power source of the voltage-withstanding insulation tester in an emergency.

Preferably, a first rolling component for moving the photovoltaic component horizontally is arranged on the first storage rack and the second storage rack; and the second storage rack is arranged on one side of the first storage rack, such that the photovoltaic component is capable of moving from the first storage rack onto the second storage rack horizontally.

Preferably, the wet leakage current test system further includes a feed rack and a discharge rack, wherein the feed rack is arranged on one side of the first storage rack away from the second storage rack, and the discharge rack is arranged on one side of the second storage rack away from the first storage rack; a second rolling component for moving the photovoltaic component horizontally is arranged on each of the feed rack and the discharge rack; and the photovoltaic component is capable of moving horizontally from the feed rack to the first storage rack, the second storage rack, and then onto the discharge rack.

Preferably, the drying apparatus includes a first air knife, a second air knife and an air blower connected with each of the first air knife and the second air knife through an air duct, wherein the first air knife is arranged above the second storage rack, and an air outlet of the first air knife faces downwards; and the second air knife is arranged at a bottom of the second storage rack, and an air outlet of the second air knife faces upwards.

Preferably, the electrical protection device includes a grating module and/or a scram module arranged around the liquid pool, wherein the grating module is configured to disable the voltage output from the voltage-withstanding insulation tester after the grating module has detected that a grating region is blocked; and the scram module is configured to cut off the power source of the voltage-withstanding insulation tester after the scram module has been triggered.

Preferably, a plurality of stoppers for limiting the horizontal movement of the photovoltaic component is arranged on the feed rack, the first storage rack, the second storage rack and the discharge rack.

Preferably, the drying apparatus further includes a dehumidification filter which is mounted at the air blower and/or the first air knife and the second air knife.

Preferably, the electrical protection device further includes an audible and visual indication module and a leakage protector, wherein the audible and visual indication module is configured to indicate different states of the wet leakage current test system for the photovoltaic component; and the leakage protector is configured to detect a residual current in a circuit system, so as to avoid electrical accidents in a humid environment.

Preferably, the drying apparatus further includes a heater arranged at the air outlet of the air blower.

Preferably, the wet leakage current test system further includes a limit device for limiting a lifting stroke of the first storage rack.

Preferably, the first rolling component and the second rolling component are each in the form of roller, roll ball or pulley.

Preferably, the stopper is rotatable, and is a laterally arranged pulley, a cylindrical shaft, a cylindrical pin or a cylindrical rod.

Preferably, the first air knife and the second air knife are capable of adjusting an air-out angle and/or an air volume.

The present disclosure further provides a wet leakage current test system for a photovoltaic component, including a liquid pool and a voltage-withstanding insulation tester, wherein the wet leakage current test system further includes a first storage rack, a lifting actuator, a second storage rack, and a drying apparatus, wherein the first storage rack is arranged above the liquid pool, and is mechanically connected with the lifting actuator; the lifting actuator is configured to drive the first storage rack to descend into the liquid pool or ascend above the liquid pool; and the drying apparatus is mounted on the second storage rack and configured to dry the photovoltaic component which moves from the first storage rack onto the second storage rack.

In the present disclosure, the first storage rack is driven by the lifting actuator to ascend from and descend into the liquid pool, instead of manually picking up the component from and placing it in the liquid pool, thereby reducing human burden and saving labor costs. Furthermore, the tested photovoltaic component is air-dried by the drying apparatus arranged on the second storage rack, which takes shorter time and dries the component uniformly compared with the nature-air drying process, thus not only avoiding water marks on the photovoltaic component, but also improving the test and production efficiencies. In addition, the electrical protection device according to the present disclosure can limit the output of the voltage-withstanding insulation tester or cut off its power, thereby further eliminating safety hazards, and improving the reliability and safety of the system.

### BRIEF DESCRIPTION OF THE DRAWINGS

In order to make the object, technical solution and advantages of the present disclosure more apparent, the present disclosure will be described below in detail in combination with the drawings, in which:
Fig. 1 is a schematic diagram of a wet leakage current test system for a photovoltaic component according to one embodiment of the present disclosure;
Fig. 2 is a schematic diagram of a wet leakage current test system for a photovoltaic component according to another embodiment of the present disclosure.

### Reference numerals:

1 liquid pool; 2 first storage rack; 3 lifting actuator; 4 second storage rack; 5 drying apparatus; 6 electrical protection device; 7 feed rack; 8 discharge rack; 9 rolling component; 10 stopper; 11 first air knife; 12 second air knife; 13 air blower; 14 air duct; 100 photovoltaic component

### DETAILED DESCRIPTION

The embodiments of the present disclosure are described in detail hereinafter. Examples of the described embodiments are given in the accompanying drawings, in which identical or similar reference numerals constantly denote identical or similar elements, or elements having identical or similar functions. The embodiments described with reference to the drawings are exemplary and merely for explaining the present disclosure, and shall not be construed as limitations of the present disclosure.

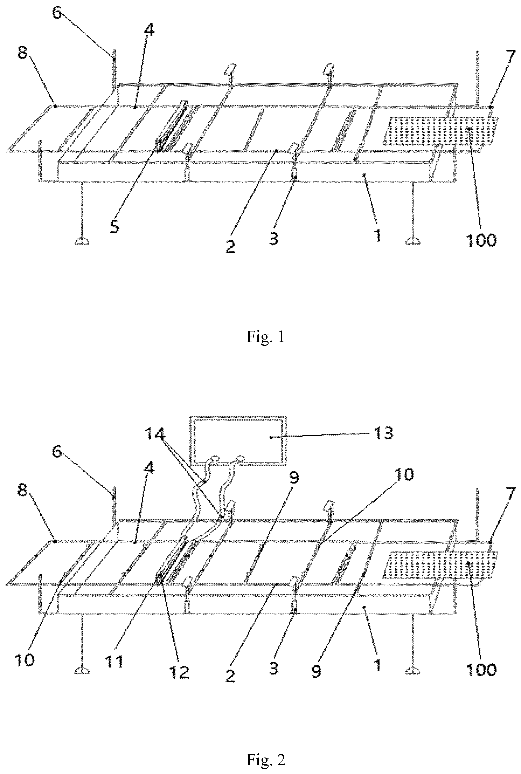

The present disclosure provides one embodiment of a wet leakage current test system for a photovoltaic component. With reference to Fig. 1, the system includes a liquid pool 1 and a voltage-withstanding insulation tester (not shown in the Figures), and further includes a first storage rack 2, a lifting actuator 3, a second storage rack 4, a drying apparatus 5 and an electrical protection device 6. As shown in Fig. 1, the first storage rack 2 may be arranged above the liquid pool 1 and mechanically connected with the lifting actuator 3 which functions to drive the first storage rack 2 to descend into the liquid pool 1 or ascend above the liquid pool 1. It should be noted that in the present embodiment, an air cylinder is used as the lifting actuator, whose movement can be electrically controlled, for example, by means of an electromagnetic valve which is connected with the lifting actuator 3 by a gas circuit and is controlled to open and close by a key or a button, or automatically controlled by a preset program. Certainly, a pure mechanical pneumatic method may be also adopted. For example, the valve is manually operated to supply or discharge air, so as to make the lifting actuator 3 act. Moreover, in order to limit the first storage rack 2 to move in an effective stroke, a limit device such as a stop block and a baffle plate may be also arranged in the first storage rack 2 and/or the liquid pool 1. For the lifting actuator 3 automatically controlled by programs, a stroke sensor, a proximity switch, or the like may be used as this limit device. In addition, although the air cylinder is used as the lifting actuator in the present embodiment, in practical operations, the air cylinder can be substituted with an oil cylinder, an electric cylinder, or a mechanism such as a hinge or an inhaul cable, in order to drive the first storage rack 2 to ascend and descend. Additionally, it should be noted that the first storage rack 2 functions to immerse the photovoltaic component 100 laid flat thereon into the liquid pool 1 or pick up the photovoltaic component 100 from the liquid pool 1. Therefore, it is conceivable that in the present embodiment, the first storage rack 2 has a size at least less than the liquid pool 1, making it possible to implement the immersion and picking-up operations. Furthermore, the second storage rack 4 is also placed above the liquid pool 1 and close to one side of the first storage rack 2 as shown in the Figures. Certainly, the second storage rack 4 may be also placed outside the liquid pool 1 and slightly away from the first storage rack 2.

The drying apparatus 5 may be mounted on the second storage rack 4, for drying the photovoltaic component 100 placed on the second storage rack 4. Specifically, for a double-glazed component, air may be blew to a front surface and a back surface of the photovoltaic component 100 laid flat on the second storage rack 4, and a drying apparatus 5 that blows air in opposite directions is thus adopted in order to dry the two surfaces of the double-glazed photovoltaic component at the same time. In addition, in practical operations, any apparatus which can provide clean and dry air, such as a fan, compressed air, an air blower, an air knife or a combination of a plurality of apparatus, may be used as the drying apparatus 5, and in order to meet the requirements of different components, the drying apparatus 5 can further adjust an air-out angle and/or an air volume.

Next, since the voltage-withstanding insulation tester would generate a relatively high DC voltage during the test, the present embodiment further provides the electrical protection device 6 electrically connected with the voltage-withstanding insulation tester, with a purpose of making it possible to disable a voltage output from the voltage-withstanding insulation tester in the case that an operator operates in a high voltage region, and even cut off a power source of the voltage-withstanding insulation tester in an emergency.

The operation mode of the present embodiment will be explained below in combination with the above-mentioned contents.

when testing, an operator lays the photovoltaic component 100 to be tested flat on the first storage rack 2, starts the lifting actuator 3 such that the first storage rack 2 on which the photovoltaic component 100 is carried descends into the liquid pool 1 and immerses therein, and turns on the voltage-withstanding insulation tester to start the test. After the test is finished, the lifting actuator 3 is started again such that the photovoltaic component 100 ascends above the liquid pool 1. The operator moves the wet photovoltaic component 100 onto the second storage rack 4, and turns on the drying apparatus 5 to dry the two surfaces of the photovoltaic component 100. In the above-mentioned process, in the case that the operator moves the photovoltaic component, the electrical protection device 6 can disable the high voltage output from the voltage-withstanding insulation tester and/or cut off its power source.

As can be seen from the present embodiment, compared with the existing test method, the operator is not needed to bend down to pick up the photovoltaic component 100 from and place it in the liquid pool 1, and the nature-air drying process is abandoned as well. Therefore, the present disclosure is capable of reducing human burden, saving labor costs, improving test and production efficiencies, and further eliminating safety hazards and ensuring the reliability and safety during the test.

In order to make the test operation more convenient, as for the above-mentioned embodiment, the present disclosure provides another preferable solution. As shown in Fig. 2, the second storage rack 4 is arranged on one side of the first storage rack 2 with the same height, and the first rolling component for moving the photovoltaic component 100 horizontally is arranged on the first storage rack 2 and the second storage rack 4, such that the photovoltaic component 100 can move smoothly and horizontally from the first storage rack 2 onto the second storage rack 4, omitting the process of transporting the first storage rack 2 to the second storage rack 4 by the operator. The operator can push the photovoltaic component 100 to move between the two storage racks effortlessly. It should be additionally noted that the first rolling component may be in the form of roller, roll ball, pulley or the like. Moreover, the person skilled in the art can be inspired from the present preferable solution to adopt the first rolling component automatically controlled by programs, and adjust rolling timing, speed and direction as needed.

Further, based on the above-mentioned preferable solution, one may additionally arrange a feed rack 7 and a discharge rack 8, and connect the feed rack 7, the first storage rack 2, the second storage rack 4 and the discharge rack 8 successively, such that the photovoltaic component 100 can move continuously, smoothly and horizontally. As shown in Figs. 1 and 2, the feed rack 7 may be arranged on one side of the first storage rack 2 away from the second storage rack 4, and the discharge rack 8 may be arranged on one side of the second storage rack 4 away from the first storage rack 2. Similarly, a second rolling component for moving the photovoltaic component 100 horizontally may be arranged on each of the feed rack 7 and the discharge rack 8. It should be additionally noted that in practical operations, the first rolling component can be the same as the second rolling component. Therefore, in the embodiment of Fig. 2, the first rolling component and the second rolling component are collectively referred to as a rolling component 9. In this way, the photovoltaic component 100 can move horizontally from the feed rack 7 to the first storage rack 2, the second storage rack 4 and then onto the discharge rack 8. The operator only needs to place photovoltaic component 100 on and remove the photovoltaic component 100 from the feed rack 7 and the discharge rack 8, and to push manually (or by electrical control) the photovoltaic component 100 to move horizontally at the first storage rack 2 and the second storage rack 4. In practical operations, in order to ensure the stable and smooth horizontal movement of the photovoltaic component 100, and to avoid the movement deviation and even falling off from each of the racks, a plurality of stoppers 10 for limiting the horizontal movement of the photovoltaic component 100 may be also arranged on the feed rack 7, the first storage rack 2, the second storage rack 4 and the discharge rack 8. The stoppers 10 can not only limit the movement direction to avoid deviation and falling, but also assist the more smooth movement of the photovoltaic component 100. Therefore, in the case of setting their specific positions, it needs to consider the size of the photovoltaic component 100, such that an edge of the photovoltaic component 100 can contact the stoppers 10 and slide. It should be also noted that the stopper 10 may be a pulley which is arranged laterally, or may be substituted with a cylindrical shaft, pin or rod, and can actively or passively rotate.

It is also mentioned above that there may be various types of drying apparatus 5. In another embodiment of the present disclosure, as shown in Fig. 2, for the double-glazed photovoltaic component, the drying apparatus 5 mainly consists of a first air knife 11, a second air knife 12 and an air blower 13 connected with each of the first air knife 11 and the second air knife 12 through air duct 14. In the embodiment, the first air knife 11 is arranged above the second storage rack 4, and its air outlet faces downwards, and the second air knife 12 is arranged at a bottom of or below the second storage rack 4, and its air outlet faces upwards. Preferably, the first air knife 11 and the second air knife 12 are arranged opposite to each other and at one end of the second storage rack 4. Meanwhile, a channel through which the photovoltaic component 100 passes on the second storage rack 4 is formed between the two air knives. In this way, when the photovoltaic component 100 moves from one end of the second storage rack 4 to the other end thereof, the air blower 13 is controlled to start by a manual switch or programs, and the first air knife 11 and the second air knife 12 blow air towards the front surface and the back surface of the photovoltaic component 100 respectively, such that the photovoltaic component 100 is air dried while moving. In addition, as described above, in practical operations, the first air knife 11 and the second air knife 12 can adjust the air-out angle as needed, and the air volume can also be adjusted at the air blower 13 or the air knives. In addition, in order to ensure the dry and clean air, a dehumidification filter, such as a physical or chemical moisture-absorbing material in combination with multilayered screen, may be mounted at the air blower 13 and/or the air knives, which is not limited herein.

In addition, in one preferable solution of the present embodiment, a heater may be arranged at an air outlet of the air blower 13, thereby making hot air blew out from the first air knife 11 and the second air knife 12, so as to accelerate the drying of the photovoltaic component 100 under the dual function of air drying and blowing. Certainly, to this end, an appropriate temperature should be set, and a conventional heating control component such as a temperature sensor and a heat protector may be also provided.

As for the above-mentioned electrical protection device 6, a plurality of existing electrical safety circuits and their components can all realize the function of disabling the voltage output or cutting off the power source. In another preferable embodiment of the present disclosure, a grating module and/or a scram module arranged around the liquid pool 1 is taken as a main structure of the electrical protection device 6, wherein the grating module forms a grating region within an operation range of the liquid pool 1. When the operator enters near the liquid pool 1 to operate, the grating module detects that the grating region is blocked, thereby triggering the voltage-withstanding insulation tester to interrupt the output, that is, to disable the voltage output from the voltage-withstanding insulation tester. In the case of an emergency, the operator may also trigger any handy scram module such as a scram button or an inhaul cable, thereby directly cutting off a power source of the voltage-withstanding insulation tester, and even a power source of the whole test system, so as to ensure adequate safety. Certainly, in order to guarantee no risk at all in the case that there is no emergency, the scram module may be triggered to cut off the power supply. Therefore, the grating module and the scram module can be arranged as needed.

In order to further improve the electrical safety of the system, in one preferable solution of the present embodiment, the electrical protection device 6 may also include an audible and visual indication module and a leakage protector. In the present embodiment, the audible and visual indication module may consist of a plurality of LEDs and a buzzer. For example, a green LED indicates normal, a yellow LED indicates that the grating region is blocked, and a red LED indicates that the scram module is triggered. In addition, the buzzer may make different warning sounds respectively in the case that the yellow LED or the red LED is lightened, so as to alert the operator. The leakage protector is configured to detect a residual current in a circuit system, so as to avoid electrical accidents in a humid environment, and further improve the reliability and safety of the present disclosure.

The configuration, features and effects of the present disclosure are explained in detail in the embodiments shown in the Figures. However, the foregoing merely describes the preferable embodiments of the present disclosure. It should be noted that the technical features in the above-mentioned embodiments and their preferable modes can be reasonably combined into a plurality of equivalent solutions by the person skilled in the art, without departing or changing the design concept and technical effects of the present disclosure. Therefore, the present disclosure is not limited to the implementation scope shown in Figures. All the changes made according to the concepts of the present disclosure, or equivalent embodiments amended by equivalent changes shall fall within the protection scope of the present disclosure without departing the spirits of the present specification and drawings.

## Claims

1. A wet leakage current test system for a photovoltaic component, comprising a liquid pool and a voltage-withstanding insulation tester, wherein the wet leakage current test system further comprises a first storage rack, a lifting actuator, a second storage rack, a drying apparatus and an electrical protection device,
wherein the first storage rack is arranged above the liquid pool, mechanically connected with the lifting actuator, and configured to receive the photovoltaic component thereon, and the lifting actuator is configured to drive the first storage rack to descend into the liquid pool or ascend above the liquid pool;
the drying apparatus is mounted on the second storage rack and configured to dry the photovoltaic component which moves from the first storage rack onto the second storage rack; and
the electrical protection device is in electrical signal connection with the voltage-withstanding insulation tester, and configured to disable a voltage output from the voltage-withstanding insulation tester in the case that an operator operates in a high voltage region, and/or to cut off a power source of the voltage-withstanding insulation tester in an emergency.

2. The wet leakage current test system according to claim 1, wherein a first rolling component for moving the photovoltaic component horizontally is arranged on the first storage rack and the second storage rack; and the second storage rack is arranged on one side of the first storage rack, such that the photovoltaic component is capable of moving from the first storage rack onto the second storage rack horizontally.

3. The wet leakage current test system according to claim 2, further comprising: a feed rack and a discharge rack,
wherein the feed rack is arranged on one side of the first storage rack away from the second storage rack, and the discharge rack is arranged on one side of the second storage rack away from the first storage rack;
a second rolling component for moving the photovoltaic component horizontally is arranged on each of the feed rack and the discharge rack; and
the photovoltaic component is capable of moving horizontally from the feed rack to the first storage rack, the second storage rack, and then onto the discharge rack.

4. The wet leakage current test system according to any one of claims 1 to 3, wherein the drying apparatus comprises a first air knife, a second air knife and an air blower connected with each of the first air knife and the second air knife through an air duct;
the first air knife is arranged above the second storage rack, and an air outlet of the first air knife faces downwards; and
the second air knife is arranged at a bottom of the second storage rack, and an air outlet of the second air knife faces upwards.

5. The wet leakage current test system according to any one of claims 1 to 3, wherein the electrical protection device comprises a grating module and/or a scram module arranged around the liquid pool,
wherein the grating module is configured to disable the voltage output from the voltage-withstanding insulation tester after the grating module has detected that a grating region is blocked; and
the scram module is configured to cut off the power source of the voltage-withstanding insulation tester after the scram module has been triggered.

6. The wet leakage current test system according to claim 2, wherein a plurality of stoppers for limiting the horizontal movement of the photovoltaic component is arranged on the feed rack, the first storage rack, the second storage rack and the discharge rack.

7. The wet leakage current test system according to claim 4, wherein the drying apparatus further comprises a dehumidification filter which is mounted at the air blower and/or the first air knife and the second air knife.

8. The wet leakage current test system according to claim 5, wherein the electrical protection device further comprises an audible and visual indication module and a leakage protector, wherein the audible and visual indication module is configured to indicate different states of the wet leakage current test system for the photovoltaic component, and the leakage protector is configured to detect a residual current in a circuit system, so as to avoid electrical accidents in a humid environment.

9. The wet leakage current test system according to claim 4, wherein the drying apparatus further comprises a heater arranged at an air outlet of the air blower.

10. The wet leakage current test system according to any one of claims 1 to 3, further comprising a limit device for limiting a lifting stroke of the first storage rack.

11. The wet leakage current test system according to claim 3, wherein the first rolling component and the second rolling component are each in the form of roller, roll ball or pulley.

12. The wet leakage current test system according to claim 6, wherein the stopper is rotatable, and is a laterally arranged pulley, a cylindrical shaft, a cylindrical pin or a cylindrical rod.

13. The wet leakage current test system according to claim 4, wherein the first air knife and the second air knife are configured to adjust an air-out angle and/or an air volume.

14. A wet leakage current test system for a photovoltaic component, comprising a liquid pool and a voltage-withstanding insulation tester, wherein the wet leakage current test system further comprises a first storage rack, a lifting actuator, a second storage rack, and a drying apparatus,
wherein the first storage rack is arranged above the liquid pool, and is mechanically connected with the lifting actuator, and the lifting actuator is configured to drive the first storage rack to descend into the liquid pool or ascend above the liquid pool, and
the drying apparatus is mounted on the second storage rack and configured to dry the photovoltaic component which moves from the first storage rack onto the second storage rack.
